# EUROPEAN PATENT APPLICATION

(11) **EP 4 492 449 A1**
(43) Date of publication of application: **15.01.2025**
(21) Application number: 23826119.2
(22) Date of filing: 02.06.2023
(51) Int. Cl.: H01L 23/10, H01L 23/16, H01L 23/31, H01L 21/56

(54) **ELECTRONIC DEVICE AND SERVER**

(30) Priority: 23.06.2022 CN 202210718236
(71) Applicant: xFusion Digital Technologies Co., Ltd., Zhengzhou, Henan 450000 (CN)
(72) Inventor: JIANG, Shuimu, Zhengzhou, Henan 450000 (CN)
(74) Representative: MERH-IP Matias Erny Reichl Hoffmann Patentanwälte PartG mbB
(86) International application number: PCT/CN2023/097947
(87) International publication number: WO 2023/246470

(57) **Abstract**

Embodiments of this application provide an electronic device and a server, and relate to the field of integrated circuit packaging technologies. The electronic device includes: a circuit board; a heat dissipation member, spaced apart from the circuit board; and a semiconductor device, located between the circuit board and the heat dissipation member, where the semiconductor device is electrically connected to the circuit board, and a first thermal interface material is disposed between the semiconductor device and the heat dissipation member, where the semiconductor device includes: a substrate, connected to the circuit board; a die, connected to a surface that is of the substrate and that faces away from the circuit board; and a housing, fixed to the substrate and around the die, where the housing includes a first side wall and a second side wall, a sealing member is disposed between the first side wall and the second side wall, and the sealing member is used for sealing between the housing and the heat dissipation member, and between the housing and the substrate. When the electronic device is immersed in electronic fluorinated liquid for heat dissipation, a thermal interface material of the electronic device can be prevented from being adversely affected by the electronic fluorinated liquid.

## Description

This application claims priority to Chinese Patent Application No. 202210718236.3, filed with the China National Intellectual Property Administration on June 23, 2022 and entitled "ELECTRONIC DEVICE AND SERVER", which is incorporated herein by reference in its entirety.

### TECHNICAL FIELD

Embodiments of this application relate to the field of chip packaging technologies, and in particular, to an electronic device and a server.

### BACKGROUND

With the evolution of Moore's law, power consumption of a chip such as a central processing unit (central processing unit, CPU for short) of a server in a data center becomes increasingly large, and a heat dissipation problem becomes increasingly prominent. Conventional air-cooled heat dissipation is approaching a bottleneck, and efficiency of air-cooled heat dissipation is low.

In a related technology, to resolve a heat dissipation problem of the server in data center, an immersive liquid cooling solution starts to be used. Currently, electronic fluorinated liquid is mainly used as an immersion medium of the server, and the electronic fluorinated liquid is not electrically conductive and can well transfer heat, so that heat dissipation efficiency of the server in the data center can be greatly improved, and energy consumption of the entire data center can be reduced.

Because the entire server is immersed in the electronic fluorinated liquid, a thermal interface material related to heat dissipation of the CPU is adversely affected by the electronic fluorinated liquid. Therefore, how to prevent the thermal interface material from being adversely affected by the electronic fluorinated liquid becomes a problem urgently to be resolved.

### SUMMARY

Embodiments of this application provide an electronic device and a server. When the electronic device is immersed in electronic fluorinated liquid for heat dissipation, a thermal interface material of the electronic device can be prevented from being adversely affected by the electronic fluorinated liquid.

According to a first aspect, an embodiment of this application provides an electronic device, including: a circuit board; a heat dissipation member, spaced apart from the circuit board; and a semiconductor device, located between the circuit board and the heat dissipation member, where the semiconductor device is electrically connected to the circuit board, and a first thermal interface material is disposed between the semiconductor device and the heat dissipation member, where the semiconductor device includes: a substrate, connected to the circuit board; a die, connected to a surface that is of the substrate and that faces away from the circuit board; and a housing, fixed to the substrate and around the die, where the housing includes a first side wall and a second side wall, a sealing member is disposed between the first side wall and the second side wall, and the sealing member is sealing between the housing and the heat dissipation member, and between the housing and the substrate.

According to the electronic device provided in this embodiment of this application, the housing is set to include the first side wall and the second side wall, and the sealing member is disposed between the first side wall and the second side wall, so that the sealing member is used for sealing between the housing and the heat dissipation member, and between the housing and the substrate. Therefore, the sealing member can isolate electronic fluorinated liquid from a thermal interface material. In this way, the electronic fluorinated liquid can be prevented from being in contact with the first thermal interface material through a gap between the heat dissipation member and the housing, and the electronic fluorinated liquid can be prevented from entering the housing through a connection part between the housing and the substrate and being in contact with a second thermal interface material, thereby helping ensure reliability of the thermal interface material, and helping ensure a heat dissipation effect of an integrated circuit.

In a possible implementation, an accommodation groove is disposed between the first side wall and the second side wall, and the accommodation groove extends in a direction pointing from the heat dissipation member to the circuit board, and penetrates through the housing; and the sealing member is accommodated in the accommodation groove, an end that is of the sealing member and that is close to the heat dissipation member abuts against the heat dissipation member, and an end that is of the sealing member and that is close to the substrate abuts against the substrate.

The accommodation groove is set to extend in the direction pointing from the heat dissipation member to the circuit board, and penetrate through the housing, and the sealing member is accommodated in the accommodation groove, so that the end that is of the sealing member and that is close to the heat dissipation member abuts against the heat dissipation member, and the end that is of the sealing member and that is close to the substrate abuts against the substrate. Therefore, sealing between the housing and the heat dissipation member and sealing between the housing and the substrate can be ensured, to better isolate the electronic fluorinated liquid from the thermal interface material, and a structure is simple and easy to manufacture.

In a possible implementation, a first groove is disposed on a surface that is of the heat dissipation member and that faces the semiconductor device, and the end that is of the sealing member and that is close to the heat dissipation member is accommodated in the first groove.

The first groove is disposed on the a surface that is of the heat dissipation member and that faces the semiconductor device, and the end that is of the sealing member and that is close to the heat dissipation member is accommodated in the first groove. Therefore, sealing performance of the sealing member between the heat dissipation member and the housing can be further improved, and the end that is of the sealing member and that is close to the heat dissipation member can be limited, to ensure mounting stability of the sealing member.

In a possible implementation, a second groove is disposed on a surface that is of the substrate and that faces the housing, and the end that is of the sealing member and that is close to the substrate is accommodated in the second groove.

The second groove is disposed on the surface that is of the substrate and that faces the housing, and the end that is of the sealing member and that is close to the substrate is accommodated in the second groove. Therefore, sealing performance of the sealing member between the housing and the substrate can be further improved, and the end that is of the sealing member and that is close to the substrate can be limited, to ensure mounting stability of the sealing member.

In a possible implementation, a width of an orthographic projection, on the housing, of a part that is of the sealing member and that is located between the housing and the heat dissipation member is greater than a width of the accommodation groove.

The width of the orthographic projection, on the housing, of the part that is of the sealing member and that is located between the housing and the heat dissipation member is set to be greater than the width of the accommodation groove. Therefore, sealing performance of the sealing member between the heat dissipation member and the housing can be further improved, and the electronic fluorinated liquid can be prevented from penetrating into the housing through the accommodation groove.

In a possible implementation, The material of the sealing member includes at least one of silica gel or butyronitrile.

The sealing member is set to include at least one of silica gel or butyronitrile. Therefore, a material of the sealing member is compatible with the electronic fluorinated liquid, and there are a large quantity of optional solutions for the material of the sealing member.

In a possible implementation, a first accommodation part and a second accommodation part are disposed between the first side wall and the second side wall, the first accommodation part is located at an end that is of the housing and that faces the heat dissipation member, and the second accommodation part is located at an end that is of the housing and that faces the substrate; the sealing member includes a first sealing part and a second sealing part; and the first sealing part is accommodated in the first accommodation part, an end that is of the first sealing part and that is close to the heat dissipation member abuts against the heat dissipation member, the second sealing part is accommodated in the second accommodation part, and an end that is of the second sealing part and that is close to the substrate abuts against the substrate.

The first accommodation part and the second accommodation part are disposed between the first side wall and the second side wall. The first sealing part is accommodated in the first accommodation part, and the end that is of the first sealing part and that is close to the heat dissipation member abuts against the heat dissipation member, so that the first sealing part is sealing between the housing and the heat dissipation member. The second sealing part is accommodated in the second accommodation part, and the end that is of the second sealing part and that is close to the substrate abuts against the substrate, so that the second sealing part is used for sealing between the housing and the substrate. In this way, the electronic fluorinated liquid can be prevented from being in contact with the first thermal interface material through the gap between the heat dissipation member and the housing, and the electronic fluorinated liquid can be prevented from entering the housing through the connection part between the housing and the substrate and being in contact with the second thermal interface material, thereby helping ensure reliability of the thermal interface material.

In a possible implementation, materials of the first sealing part and the second sealing part are the same, or materials of the first sealing part and the second sealing part are different.

The materials of the first sealing part and the second sealing part are set to be the same or different, so that material selection of the first sealing part or the second sealing part is more flexible.

In a possible implementation, the housing further includes a top wall, and the top wall is connected to an end that is of the first side wall and that is close to the heat dissipation member; the first thermal interface material is located between the top wall and the heat dissipation member; and a second thermal interface material is disposed between the top wall and the die.

The housing is set to further include the top wall, and the top wall is connected to the end that is of the first side wall and that is close to the heat dissipation member, so that the die can be better packaged. The first thermal interface material is set to be located between the top wall and the heat dissipation member, and the second thermal interface material is disposed between the top wall and the die, so that heat of the die can be better transferred to the heat dissipation member, to quickly dissipate the heat.

According to a second aspect, an embodiment further provides a server, including at least one electronic device according to the first aspect. Therefore, when the server is immersed in electronic fluorinated liquid for heat dissipation, a thermal interface material of the server can be prevented from being adversely affected by the electronic fluorinated liquid.

### BRIEF DESCRIPTION OF DRAWINGS

FIG. 1 is a schematic diagram of a structure of an integrated circuit according to a related technology;
FIG. 2 is a schematic diagram 1 of a structure of an integrated circuit according to an embodiment of this application;
FIG. 3 is a schematic diagram 1 of a structure in a manufacturing process of the integrated circuit in FIG. 2;
FIG. 4 is a schematic diagram 2 of a structure in a manufacturing process of the integrated circuit in FIG. 2;
FIG. 5 is a schematic diagram 3 of a structure in a manufacturing process of the integrated circuit in FIG. 2;
FIG. 6 is a schematic diagram 2 of a structure of an integrated circuit according to an embodiment of this application;
FIG. 7 is a schematic diagram 3 of a structure of an integrated circuit according to an embodiment of this application;
FIG. 8 is a schematic diagram 1 of a structure in a manufacturing process of the integrated circuit in FIG. 7;
FIG. 9 is a schematic diagram 2 of a structure in a manufacturing process of the integrated circuit in FIG. 7;
FIG. 10 is a schematic diagram 3 of a structure in a manufacturing process of the integrated circuit in FIG. 7;
FIG. 11 is a schematic diagram 4 of a structure of an integrated circuit according to an embodiment of this application;
FIG. 12 is a schematic diagram 5 of a structure of an integrated circuit according to an embodiment of this application; and
FIG. 13 is a schematic diagram of a structure of an electronic device according to an embodiment of this application.

### Reference numerals:

100, 100'-semiconductor device;
110, 110'-substrate; 111-second groove;
120, 120'-die;
130, 130'-housing; 1301-side wall; 1302-top wall; 131-first component; 1311-first side wall; 132-second component; 1321-second side wall; 133-accommodation groove; 1331-first accommodation part; 1332-second accommodation part;
200, 200'-integrated circuit;
210, 210'-circuit board;
220, 220'-heat dissipation member; 221-first groove; 222, 222'-screw;
231, 232'-second thermal interface material; 232, 23 1'-first thermal interface material;
240-sealing member; 241-first sealing part; 242-second sealing part;
300-electronic device.

### DESCRIPTION OF EMBODIMENTS

Terms used in implementations of this application are merely used to explain specific embodiments of this application, and are not intended to limit this application. The following describes implementations of embodiments of this application in detail with reference to the accompanying drawings

A printed circuit board (Printed circuit boards, PCB), also referred to as a printed circuit board, is an electrical connection provider of an electronic passive element. A chip is a core part of an electronic device, and has a function of logic processing and controlling normal running of the entire device. In the electronic device, the chip is mainly fixed to a printed circuit board in a form of a chip packaging structure, to stably control stable conduction between the chip inside the chip packaging structure and the external printed circuit board. A flip chip (Flip Chip) is a chip interconnection technology, and is also an ideal chip bonding technology. The chip has become a commonly used packaging form in the field of high-end devices and high-density packaging.

A die (die) is a chip that is not packaged after a wafer is cut and tested. Generally, only a pressure welding point used for packaging is on the die, and the die cannot be directly applied to an actual circuit. The die is easily affected by the temperature, impurities, and physical force in an external environment, and is easily damaged. Therefore, the die needs to be packaged in space and provided with a corresponding pin, so as to be used as a basic component.

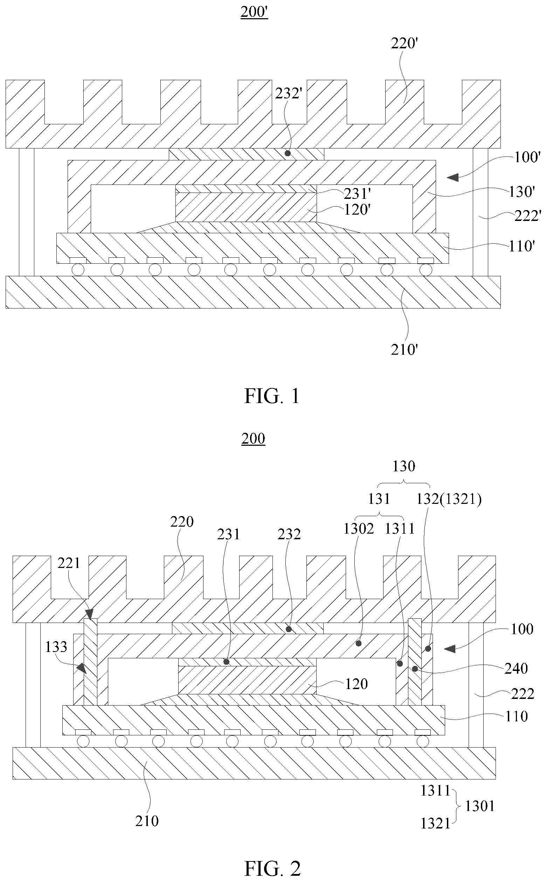

Referring to FIG. 1, in a related technology, an integrated circuit 200' includes a circuit board 210', a heat dissipation member 220', and a semiconductor device 100'. The heat dissipation member 220' is spaced apart from the circuit board 210', and the heat dissipation member 220' may be connected to the circuit board 210' by using a screw 222'. The semiconductor device 100' is disposed between the circuit board 210' and the heat dissipation member 220', and the semiconductor device 100' is electrically connected to the circuit board 210'.

The semiconductor device 100', for example, a CPU chip of a server, generally includes a substrate 110', a die 120', and a housing 130'. A lower surface of the substrate 110' is connected to the circuit board 210'. The die 120' is connected to an upper surface of the substrate 110'. The housing 130' covers the die 120', and a bottom end of the housing 130' is connected to the upper surface of the substrate 110' through sealing. A first thermal interface material 231' is disposed between a surface that is of a top wall of the housing 130' and that faces the substrate 110' and a surface that is of the die 120' and that faces away from the substrate 110', and a second thermal interface material 232' is disposed between a surface that is of the top wall of the housing 130' and that faces the heat dissipation member 220' and a surface that is of the heat dissipation member 220' and that faces the housing 130'.

However, when the integrated circuit 200' in the related technology is immersed in electronic fluorinated liquid for heat dissipation, the electronic fluorinated liquid is in contact with the second thermal interface material 232' through a gap between the heat dissipation member 220' and the housing 130', and enters the housing 130' through a connection part between the housing 130' and the substrate 110', and is in contact with the first thermal interface material 231'. The electronic fluorinated liquid adversely affects the first thermal interface material 231' and the second thermal interface material 232', and consequently reliability of the first thermal interface material 231' and the second thermal interface material 232' is reduced.

Based on this, the embodiments of this application provide an integrated circuit, and an electronic device and a server that include the integrated circuit. The integrated circuit includes a circuit board, a heat dissipation member connected to the circuit board, and a semiconductor device disposed between the circuit board and the heat dissipation member. A thermal interface material is disposed between the semiconductor device and the heat dissipation member. The semiconductor device includes a substrate connected to the circuit board, a die connected to the substrate, and a housing fixed between the substrate and the heat dissipation member around the die. A sealing member is disposed between the housing and the heat dissipation member, and between the housing and the substrate, so that an orthographic projection of the sealing member on the heat dissipation member surrounds an orthographic projection of the thermal interface material on the heat dissipation member. Therefore, the sealing member can isolate electronic fluorinated liquid from the thermal interface material. In this way, the electronic fluorinated liquid can be prevented from being in contact with the thermal interface material through a gap between the heat dissipation member and the housing, and the electronic fluorinated liquid can be prevented from entering the housing through a connection part between the housing and the substrate and being in contact with the thermal interface material, thereby helping ensure reliability of the thermal interface material, and helping ensure a heat dissipation effect of the integrated circuit.

With reference to the accompanying drawings, the following describes in detail specific structures of the integrated circuit, the electronic device, and the server.

Referring to FIG. 2, an embodiment of this application provides an integrated circuit 200.

The integrated circuit 200 includes a circuit board 210, a heat dissipation member 220, and a semiconductor device 100. The heat dissipation member 220 is spaced apart from the circuit board 210. For example, the heat dissipation member 220 may be fastened and connected to the circuit board 210 by using a fastener such as a screw 222. The semiconductor device 100 is located between the circuit board 210 and the heat dissipation member 220, the semiconductor device 100 is electrically connected to the circuit board 210, and a first thermal interface material 232 is disposed between the semiconductor device 100 and the heat dissipation member 220.

For example, a surface that is of the heat dissipation member 220 and that faces the circuit board 210 may be disposed as a flat surface, so that the surface that is of the heat dissipation member 220 and that faces the circuit board 210 can be in close contact with the semiconductor device 100 by using the first thermal interface material 232, and heat of the semiconductor device 100 can be transferred to the heat dissipation member 220 by using the first thermal interface material 232. A plurality of heat dissipation fins may be disposed at intervals on a surface that is of the heat dissipation member 220 and that faces away from the circuit board 210, and the plurality of heat dissipation fins may increase a heat dissipation area of the heat dissipation member 220, so that heat transferred to the heat dissipation member 220 can be quickly dissipated by using the heat dissipation fins.

The semiconductor device 100 includes a substrate 110, a die 120, and a housing 130. The substrate 110 includes an upper surface and a lower surface that are opposite to each other, and the lower surface of the substrate 110 faces the circuit board 210, and is connected to the circuit board 210. For example, the lower surface of the substrate 110 may be connected to the circuit board 210 through solder ball soldering. Alternatively, a plug-in structure may be disposed on the lower surface of the substrate 110, a socket structure may be disposed on a surface that is of the circuit board 210 and that faces the substrate 110, and the plug-in structure matches and is plugged into the socket structure, to connect the substrate 110 to the circuit board 210.

The upper surface of the substrate 110 faces away from the circuit board 210, and the die 120 is connected to the upper surface of the substrate 110. For example, the die 120 may be connected to the substrate 110 through solder ball soldering, so that the die 120 and the substrate 110 are electrically connected. In addition, underfill may be filled between the die 120 and the substrate 110, and the underfill may ensure reliability of the electrical connection between the die 120 and the substrate 110, and may also ensure stability when the die 120 is disposed on the substrate 110.

The housing 130 is fixed to the substrate 110 around the die 120. At least one passive element may be disposed in a region that is of the substrate 110 and that is located between the housing 130 and the die 120, so that the semiconductor device 100 can integrate more elements and functions, thereby improving performance and an electrical characteristic of the integrated circuit 200.

A sealing member 240 is used for sealing between the housing 130 and the heat dissipation member 220, and between the housing 130 and the substrate 110. An orthographic projection of the sealing member 240 on the heat dissipation member 220 surrounds an orthographic projection of the first thermal interface material 232 on the heat dissipation member 220. Therefore, when the integrated circuit 200 is immersed in a heat dissipation working medium such as electronic fluorinated liquid, the sealing member 240 can isolate the heat dissipation working medium from the first thermal interface material 232.

Still referring to FIG. 2, the housing 130 includes a first component 131 and a second component 132. The first component 131 is fixed to the substrate 110 around the die 120, the second component 132 is fixed to the substrate 110 around the first component 131, and an accommodation groove 133 is formed between the first component 131 and the second component 132.

The first component 131 includes a first side wall 1311 and a top wall 1302. The first side wall 1311 surrounds a circumference of the die 120, and a bottom end of the first side wall 1311 is fixedly connected to the substrate 110. For example, the bottom end of the first side wall 1311 may be fixed to the substrate 110 by using adhesive. The top wall 1302 covers a top end of the first side wall 1311. For example, the top wall 1302 and the first side wall 1311 are an integral part. The top wall 1302 of the first component 131 is a top wall 1302 of the housing 130.

A first thermal interface material 232 is disposed between a surface that is of the top wall 1302 and that faces the heat dissipation member 220 and a surface that is of the heat dissipation member 220 and that faces the top wall 1302. A second thermal interface material 231 is disposed between a surface that is of the top wall 1302 and that faces the die 120 and a surface that is of the die 120 and that faces the top wall 1302. The orthographic projection of the sealing member 240 on the heat dissipation member 220 surrounds both an orthographic projection of the first thermal interface material 232 on the heat dissipation member 220 and an orthographic projection of the second thermal interface material 231 on the heat dissipation member.

The second thermal interface material 231 is used to transfer heat generated by the die 120 to the top wall 1302. For example, the second thermal interface material 231 includes at least one of silicone grease or metallic silver. The first thermal interface material 232 is used to continue to transfer, to the heat dissipation member 220, the heat transferred by the die 120 to the top wall 1302. For example, the first thermal interface material 232 includes at least one of a carbon fiber thermal pad, a gel, a silicone grease, or a phase change thermal material.

The second component 132 may also be referred to as a second side wall 1321, and the second side wall 1321 surrounds a circumference of the first side wall 1311, and a bottom end of the second side wall 1321 is fixedly connected to the substrate 110. For example, the bottom end of the second side wall 1321 may be fixed to the substrate 110 by using adhesive. A top end of the second side wall 1321 may be flush with the top end of the first side wall 1311. Alternatively, a top end of the second side wall 1321 may be lower than the top end of the first side wall 1311. Alternatively, a top end of the second side wall 1321 may be higher than the top end of the first side wall 1311. The first side wall 1311 and the second side wall 1321 jointly form a side wall 1301 of the housing 130.

The second side wall 1321 and the first side wall 1311 are spaced apart from each other to form the accommodation groove 133. It may be understood that the accommodation groove 133 extends in a direction pointing from the heat dissipation member 220 to the circuit board 210, and penetrates through the housing 130, and the accommodation groove 133 surrounds, by one circle, a side that is of the first side wall 1311 and that faces the second side wall 1321. A surrounding shape of the accommodation groove 133 includes but is not limited to a square, a rectangle, and a circle. In a possible implementation, a width range of the accommodation groove 133 may be set to 2 mm to 4 mm. For example, a width of the accommodation groove 133 may be set to 2 mm, 2.5 mm, 3 mm, 3.5 mm, 4 mm, or any value between 2 mm to 4 mm based on an actual requirement.

In a possible implementation, materials of the first component 131 and the second component 132 may be the same. For example, the materials of the first component 131 and the second component 132 may be a copper-based material with nickel plated on a surface. In another possible implementation, materials of the first component 131 and the second component 132 may be different.

The sealing member 240 is accommodated in the accommodation groove 133, and the sealing member 240 extends in the accommodation groove 133 in the direction pointing from the heat dissipation member 220 to the circuit board 210, and penetrates through the housing 130. It may be understood that the sealing member 240 extends in the accommodation groove 133 which is between the first side wall 1311 and the second side wall 1321, and surrounds the first side wall 1311 by one circle. For example, the material of the sealing member 240 includes at least one of silica gel or butyronitrile. The sealing member 240 includes but is not limited to an O-ring, a square ring, and a rectangular ring. A shape of the sealing member 240 may be the same as or different from the surrounding shape of the accommodation groove 133, provided that the sealing member 240 can be accommodated in the accommodation groove 133 and provide a sealing function. An end that is of the sealing member 240 and that is close to the heat dissipation member 220 abuts against the heat dissipation member 220, to implement sealing between the housing 130 and the heat dissipation member 220. An end that is of the sealing member 240 and that is close to the substrate 110 abuts against the substrate 110, to implement sealing between the housing 130 and the substrate 110.

In a possible implementation, a first groove 221 may be disposed on a surface that is of the heat dissipation member 220 and that faces the housing 130, and the first groove 221 corresponds to the end that is of the sealing member 240 and that is close to the heat dissipation member 220, so that the end that is of the sealing member 240 and that is close to the heat dissipation member 220 is accommodated in the first groove 221, to abut against the heat dissipation member 220. Therefore, the sealing member 240 can better seal a gap between the housing 130 and the heat dissipation member 220, to prevent the heat dissipation working medium such as electronic fluorinated liquid from being in contact with the first thermal interface material 232 through the gap between the housing 130 and the heat dissipation member 220, thereby helping ensure reliability of the first thermal interface material 232, and helping ensure a heat dissipation effect of the integrated circuit 200.

In a possible implementation, a depth range of the first groove 221 may be set to 1 mm to 2 mm. For example, a depth of the first groove 221 may be set to 1 mm, 1.3 mm, 1.5 mm, 1.7 mm, 2 mm, or any value between 1 mm to 2 mm based on an actual requirement.

In another possible implementation, the first groove may not be disposed on the surface that is of the heat dissipation member and that faces the housing, so that the end that is of the sealing member and that is close to the heat dissipation member directly abuts against and is pressed against the surface that is of the heat dissipation member and that faces the housing.

In a possible implementation, a second groove (not shown in the figure) may be disposed on a surface that is of the substrate and that faces the housing, and the second groove corresponds to the end that is of the sealing member and that is close to the substrate, so that the end that is of the sealing member and that is close to the substrate is accommodated in the second groove, to abut against the substrate.

In another possible implementation, the second groove may not be disposed on the surface that is of the substrate 110 and that faces the housing 130, so that the end that is of the sealing member 240 and that is close to the substrate 110 directly abuts against and is pressed against the side that is of the substrate 110 and that faces the housing 130. Therefore, the sealing member 240 can better seal a connection part between the housing 130 and the substrate 110, to prevent the heat dissipation working medium such as electronic fluorinated liquid from entering the housing 130 through the connection part between the housing 130 and the substrate 110 and being in contact with the second thermal interface material 231, thereby helping ensure reliability of the second thermal interface material 231, and helping ensure a heat dissipation effect of the integrated circuit 200.

A manufacturing process of the integrated circuit 200 in this embodiment of this application mainly includes the following steps:

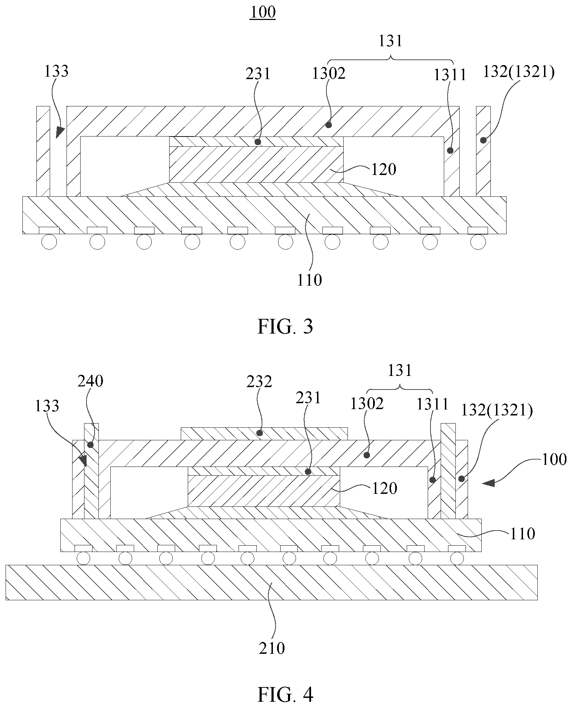

Referring to FIG. 3, the first component 131 and the second component 132 are placed at preset positions on the substrate 110, so that the accommodation groove 133 is formed between the first component 131 and the second component 132. The first component 131 and the second component 132 are connected to the substrate 110 through curing by using adhesive, to complete packaging of the semiconductor device 100.

Referring to FIG. 4, the packaged semiconductor device 100 is disposed at a preset position on the circuit board 210. For example, the semiconductor device 100 may be electrically connected to the preset position on the circuit board 210 through welding or insertion. The sealing member 240 is placed in the accommodation groove 133 between the first component 131 and the second component 132. The first thermal interface material 232 is disposed on a surface that is of the top wall 1302 of the first component 131 and that faces away from the substrate 110. For example, the first thermal interface material 232 may be placed or coated on the surface that is of the top wall 1302 of the first component 131 and that faces away from the substrate 110. The sealing member 240 surrounds a circumference of the first thermal interface material 232.

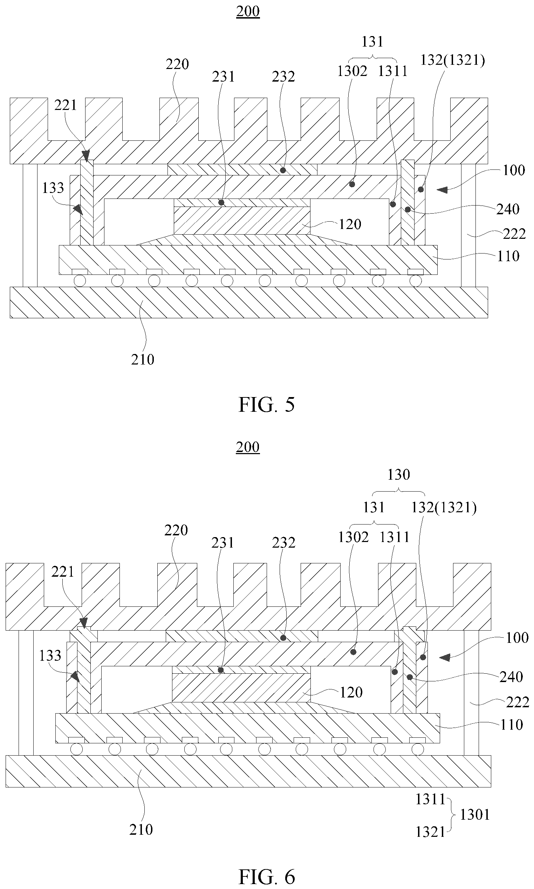

Referring to FIG. 5, the heat dissipation member 220 is disposed on a surface that is of the first thermal interface material 232 and that faces away from the semiconductor device 100, and the heat dissipation member 220 may be fixedly connected to the circuit board 210 by using a fastener such as the screw 222. For example, there may be a plurality of screws, and the plurality of screws may be arranged at intervals in a circumferential direction of the semiconductor device 100. The heat dissipation member 220 is tightly attached to the surface that is of the first thermal interface material 232 and that faces away from the semiconductor device 100, to ensure an effect that heat of the semiconductor device 100 is conducted from the first thermal interface material 232 to the heat dissipation member 220. In addition, the heat dissipation member 220 is pressed against the sealing member 240, so that the end that is of the sealing member 240 and that is close to the heat dissipation member 220 abuts against the heat dissipation member 220, and the end that is of the sealing member 240 and that is close to the substrate 110 abuts against the substrate 110, thereby ensuring a sealing effect of the sealing member 240.

An embodiment of this application further provides a specific integrated circuit. A size of a die is 35 mm*35 mm, power consumption of the die is 300 W, and a peripheral size of a housing is 75 mm*75 mm. A first component includes a first side wall and a top wall, a material of the first component is a copper-based material with nickel plated on a surface, a material of the second component is the same as the material of the first component, and a distance between the second component and the first component is 2 mm to 4 mm. A sealing member is a silica gel or butyronitrile rubber ring that has good sealing and waterproof effects and good elasticity and that is compatible with fluorinated liquid. A depth range of a first groove on a heat dissipation member is 1 mm to 2 mm. The heat dissipation member is fastened and connected to a circuit board by using a screw, and fastening force may be 30 kg.

Referring to FIG. 6, an embodiment of this application provides an integrated circuit 200. A difference between the integrated circuit 200 and the integrated circuit shown in FIG. 2 lies in that a width of an orthographic projection, on the housing 130, of a part that is of the sealing member 240 and that is located between the housing 130 and the heat dissipation member 220 is greater than a width of the accommodation groove 133. In a possible implementation, the part that is of the sealing member 240 and that is located between the housing 130 and the heat dissipation member 220 may totally cover the accommodation groove 133, and may extend to both sides of an opening of the accommodation groove 133. In another possible implementation, the part that is of the sealing member 240 and that is located between the housing 130 and the heat dissipation member 220 may totally cover the accommodation groove 133, and may extend to one side of an opening of the accommodation groove 133. For another feature and a manufacturing process of the integrated circuit shown in FIG. 6, refer to the foregoing descriptions about the integrated circuit in FIG. 2. Details are not described herein again.

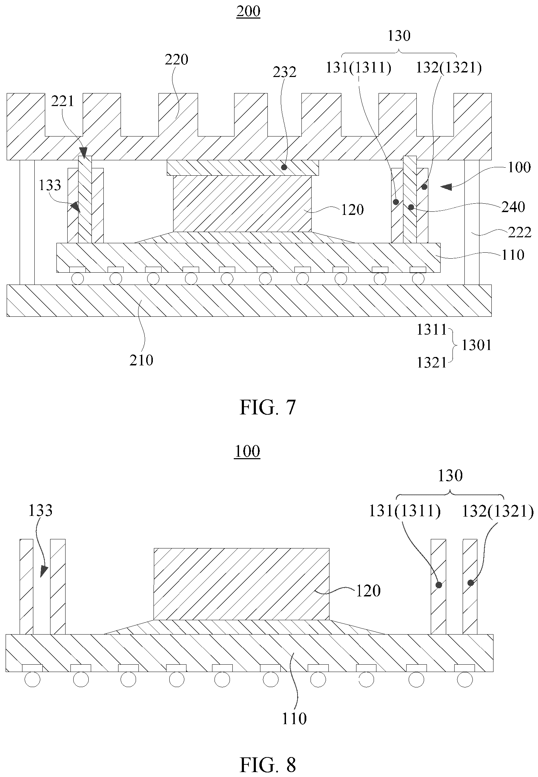

Referring to FIG. 7, an embodiment of this application further provides an integrated circuit 200. The housing 130 of the integrated circuit 200 includes a first component 131 and a second component 132. The first component 131 is fixed to the substrate 110 around the die 120, the second component 132 is fixed to the substrate 110 around the first component 131, and an accommodation groove 133 is formed between the first component 131 and the second component 132.

Different from the integrated circuit shown in FIG. 2, the first component 131 of the integrated circuit in FIG. 7 does not include a top wall 1302. The first component 131 may also be referred to as a first side wall 1311, and surrounds a circumference of the die 120, and a bottom end of the first side wall 1311 is fixedly connected to the substrate 110. For example, the bottom end of the first side wall 1311 may be fixed to the substrate 110 by using adhesive.

The second component 132 may also be referred to as a second side wall 1321, and the second side wall 1321 surrounds a circumference of the first side wall 1311, and a bottom end of the second side wall 1321 is fixedly connected to the substrate 110. For example, the bottom end of the second side wall 1321 may be fixed to the substrate 110 by using adhesive. A top end of the second side wall 1321 may be flush with the top end of the first side wall 1311. Alternatively, a top end of the second side wall 1321 may be lower than the top end of the first side wall 1311. Alternatively, a top end of the second side wall 1321 may be higher than the top end of the first side wall 1311. The first side wall 1311 and the second side wall 1321 jointly form a side wall 1301 of the housing. There is a gap between each of a top end of the first component 131 and a top end of the second component 132 and a surface that is of the heat dissipation member 220 and that faces the semiconductor device 100, to prevent the heat dissipation member 220 from crushing the semiconductor device 100.

A first thermal interface material 232 is disposed between a surface that is of the die 120 and that faces the heat dissipation member 220 and a surface that is of the heat dissipation member 220 and that faces the die 120. The first thermal interface material 232 is used to directly transfer heat generated by the die 120 to the heat dissipation member 220, to help ensure a heat dissipation effect of the die 120. For example, the first thermal interface material 232 includes at least one of silicone grease, metallic silver, a carbon fiber thermal pad, a gel, or a phase change thermal material.

In a possible implementation, a first groove 221 may be disposed on a surface that is of the heat dissipation member 220 and that faces the housing 130, and the first groove 221 corresponds to the end that is of the sealing member 240 and that is close to the heat dissipation member 220, so that the end that is of the sealing member 240 and that is close to the heat dissipation member 220 is accommodated in the first groove 221, to abut against the heat dissipation member 220. Therefore, the sealing member 240 can better seal a gap between the housing 130 and the heat dissipation member 220, to prevent the heat dissipation working medium such as electronic fluorinated liquid from being in contact with the first thermal interface material 232 through the gap between the housing 130 and the heat dissipation member 220, thereby helping ensure reliability of the first thermal interface material 232, and helping ensure a heat dissipation effect of the integrated circuit 200.

In another possible implementation, the first groove 221 may not be disposed on the surface that is of the heat dissipation member 220 and that faces the housing 130, so that the end that is of the sealing member 240 and that is close to the heat dissipation member 220 directly abuts against and is pressed against the surface that is of the heat dissipation member 220 and that faces the housing 130.

In a possible implementation, a second groove 111 (not shown in the figure) may be disposed on a surface that is of the substrate 110 and that faces the housing 130, and the second groove 111 corresponds to the end that is of the sealing member 240 and that is close to the substrate 110, so that the end that is of the sealing member 240 and that is close to the substrate 110 is accommodated in the second groove 111, to abut against the substrate 110.

In another possible implementation, the second groove 111 may not be disposed on the surface that is of the substrate 110 and that faces the housing 130, so that the end that is of the sealing member 240 and that is close to the substrate 110 directly abuts against and is pressed against the surface that is of the substrate 110 and that faces the housing 130. Therefore, the sealing member 240 can better seal a connection part between the housing 130 and the substrate 110, to prevent the heat dissipation working medium such as electronic fluorinated liquid from entering the housing 130 through the connection part between the housing 130 and the substrate 110 and being in contact with the first thermal interface material 232, thereby helping ensure reliability of the first thermal interface material 232, and helping ensure a heat dissipation effect of the integrated circuit 200.

A manufacturing process of the integrated circuit 200 in this embodiment of this application mainly includes the following steps:

Referring to FIG. 8, the first component 131 and the second component 132 are placed at preset positions on the substrate 110, so that the accommodation groove 133 is formed between the first component 131 and the second component 132. The first component 131 and the second component 132 are connected to the substrate 110 through curing by using adhesive, to complete packaging of the semiconductor device 100. In this case, neither the first component 131 nor the second component 132 enclose a surface that is of the die 120 and that faces away from the substrate 110.

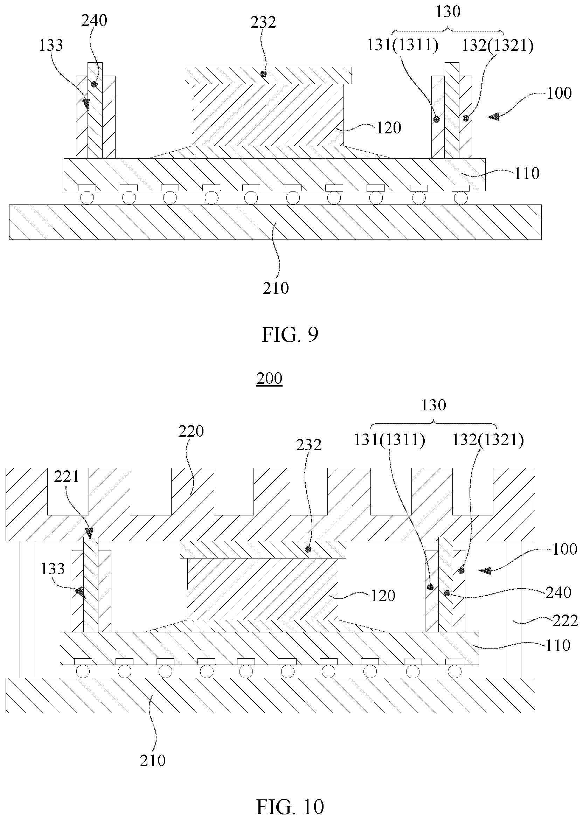

Referring to FIG. 9, the packaged semiconductor device 100 is disposed at a preset position on the circuit board 210. For example, the semiconductor device 100 may be electrically connected to the preset position on the circuit board 210 through welding or insertion. The sealing member 240 is placed in the accommodation groove 133 between the first component 131 and the second component 132. The first thermal interface material 232 is disposed on the surface that is of the die 120 and that faces away from the substrate 110. For example, the first thermal interface material 232 may be placed or coated on the surface that is of the die 120 and that faces away from the substrate 110. The sealing member 240 surrounds a circumference of the first thermal interface material 232.

Referring to FIG. 10, the heat dissipation member 220 is disposed on a surface that is of the first thermal interface material 232 and that faces away from the die 120, and the heat dissipation member 220 may be fixedly connected to the circuit board 210 by using a fastener such as the screw 222. For example, there may be a plurality of screws, and the plurality of screws may be arranged at intervals in a circumferential direction of the semiconductor device 100. The heat dissipation member 220 is tightly attached to the surface that is of the first thermal interface material 232 and that faces away from the die 120, to ensure an effect that heat of the die 120 is conducted from the first thermal interface material 232 to the heat dissipation member 220. In addition, the heat dissipation member 220 is pressed against the sealing member 240, so that the end that is of the sealing member 240 and that is close to the heat dissipation member 220 abuts against the heat dissipation member 220, and the end that is of the sealing member 240 and that is close to the substrate 110 abuts against the substrate 110, thereby ensuring a sealing effect of the sealing member 240.

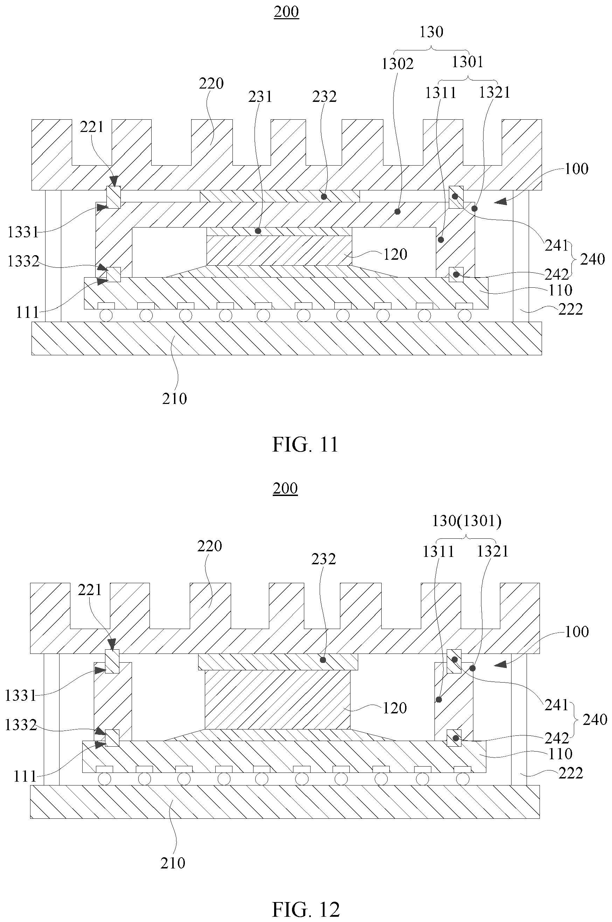

Referring to FIG. 11, an embodiment of this application further provides an integrated circuit 200. The sealing member 240 of the integrated circuit 200 may include a first sealing part 241 and a second sealing part 242 that are separated from each other. The first sealing part 241 is disposed between the housing 130 and the heat dissipation member 220 through sealing, to implement sealing between the housing 130 and the heat dissipation member 220. The second sealing part 242 is disposed between the housing 130 and the substrate 110 through sealing, to implement sealing between the housing 130 and the substrate 110. For example, materials of the first sealing part 241 and the second sealing part 242 may be the same or different. The material of the first sealing part 241 may include at least one of silica gel or butyronitrile, and the second sealing part 242 may include at least one of silica gel or butyronitrile.

Still referring to FIG. 11, the housing 130 includes a side wall 1301 and a top wall 1302. The side wall 1301 surrounds a circumference of the die 120, and a bottom end of the side wall 1301 is fixedly connected to the substrate 110. For example, the bottom end of the side wall 1301 may be fixed to the substrate 110 by using adhesive. The top wall 1302 covers a top end of the side wall 1301. For example, the top wall 1302 and the side wall 1301 are an integral part. A second thermal interface material 231 is also disposed between a surface that is of the top wall 1302 and that faces the die 120 and a surface that is of the die 120 and that faces the top wall 1302, and a first thermal interface material 232 is disposed between a surface that is of the top wall 1302 and that faces the heat dissipation member 220 and a surface that is of the heat dissipation member 220 and that faces the top wall 1302, to ensure a heat dissipation effect of the semiconductor device 100.

The side wall 1301 includes a first side wall 1311 and a second side wall 1321, and a first accommodation part 1331 and a second accommodation part 1332 are disposed between the first side wall 1311 and the second side wall 1321. The first accommodation part 1331 is located at an end that is of the housing 130 and that faces the heat dissipation member 220. An end that is of the first sealing part 241 and that is close to the housing 130 is accommodated in the first accommodation part 1331, and an end that is of the first sealing part 241 and that is close to the heat dissipation member 220 abuts against the heat dissipation member 220, to improve sealing reliability of the first sealing part 241 between the housing 130 and the heat dissipation member 220. In a possible implementation, a width range of the first accommodation part 1331 may be set to 2 mm to 4 mm. For example, a width of the first accommodation part 1331 may be set to 2 mm, 2.5 mm, 3 mm, 3.5 mm, 4 mm, or any value between 2 mm to 4 mm based on an actual requirement.

The second accommodation part 1332 is located at an end that is of the housing 130 and that faces the substrate 110. An end that is of the second sealing part 242 and that is close to the housing 130 is accommodated in the second accommodation part 1332, and an end that is of the second sealing part 242 and that is close to the substrate 110 abuts against the substrate 110, to improve sealing reliability of the second sealing part 242 between the housing 130 and the substrate 110. In a possible implementation, a width range of the second accommodation part 1332 may be set to 2 mm to 4 mm. For example, a width of the second accommodation part 1332 may be set to 2 mm, 2.5 mm, 3 mm, 3.5 mm, 4 mm, or any value between 2 mm to 4 mm based on an actual requirement.

Still referring to FIG. 11, a first groove 221 is disposed on a surface that is of the heat dissipation member 220 and that faces the semiconductor device 100, and the end that is of the first sealing part 241 and that is close to the heat dissipation member 220 is accommodated in the first groove 221, to further improve sealing reliability of the first sealing part 241 between the housing 130 and the heat dissipation member 220. In a possible implementation, a depth range of the first groove 221 may be set to 1 mm to 2 mm. For example, a depth of the first groove 221 may be set to 1 mm, 1.3 mm, 1.5 mm, 1.7 mm, 2 mm, or any value between 1 mm to 2 mm based on an actual requirement.

A second groove 111 is disposed on a surface that is of the substrate 110 and that faces the housing 130, and the end that is of the second sealing part 242 and that is close to the substrate 110 is accommodated in the second groove 111, to further improve sealing reliability of the second sealing part 242 between the housing 130 and the substrate 110.

In another possible implementation, the first groove 221 may not be disposed on the surface that is of the heat dissipation member 220 and that faces the housing 130, so that the end that is of the first sealing part 241 and that is close to the heat dissipation member 220 directly abuts against and is pressed against the surface that is of the heat dissipation member 220 and that faces the housing 130. The second groove 111 may not be disposed on the surface that is of the substrate 110 and that faces the housing 130, so that the end that is of the sealing member 240 and that is close to the substrate 110 directly abuts against and is pressed against the surface that is of the substrate 110 and that faces the housing 130.

An embodiment of this application further provides a specific integrated circuit. A size of a die is 35 mm*35 mm, power consumption of the die is 300 W, and a peripheral size of a housing is 75 mm*75 mm. The housing includes a side wall and a top wall, and a material of the housing is a copper-based material with nickel plated on a surface. A first accommodation part is disposed in a middle region of a top end of the side wall, a second accommodation part is disposed in a middle region of a bottom end of the side wall, and width ranges of the first accommodation part and the second accommodation part are 2 mm to 4 mm. The material of a first sealing part and a second sealing part each are a silica gel or butyronitrile rubber ring that has good sealing and waterproof effects and good elasticity and that is compatible with fluorinated liquid. During specific operation, the second sealing part is accommodated in the second accommodation part. The bottom end of the side wall of the housing is connected to a substrate through curing, to complete packaging of a semiconductor device. The packaged semiconductor device is welded to or inserted into a preset position on a circuit board. The first sealing part is accommodated in the first accommodation part. A heat dissipation member is fastened and connected to the circuit board by using a screw, and fastening force may be 30 kg.

Referring to FIG. 12, an embodiment of this application further provides an integrated circuit 200. Different from the integrated circuit shown in FIG. 11, the housing 130 of the integrated circuit 200 includes a side wall 1301, and does not include a top wall 1302. The side wall 1301 surrounds a circumference of the die 120, and a bottom end of the side wall 1301 is fixedly connected to the substrate 110. For example, the bottom end of the side wall 1301 may be fixed to the substrate 110 by using adhesive.

A first thermal interface material 232 is disposed between a surface that is of the die 120 and that faces the heat dissipation member 220 and a surface that is of the heat dissipation member 220 and that faces the die 120. The first thermal interface material 232 is used to directly transfer heat generated by the die 120 to the heat dissipation member 220, to help ensure a heat dissipation effect of the die 120.

The side wall 1301 includes a first side wall 1311 and a second side wall 1321, and a first accommodation part 1331 and a second accommodation part 1332 are disposed between the first side wall 1311 and the second side wall 1321. The first accommodation part 1331 is located at an end that is of the side wall 1301 and that faces the heat dissipation member 220. An end that is of the first sealing part 241 and that is close to the housing 130 is accommodated in the first accommodation part 1331, and an end that is of the first sealing part 241 and that is close to the heat dissipation member 220 abuts against the heat dissipation member 220, to improve sealing reliability of the first sealing part 241 between the housing 130 and the heat dissipation member 220.

The second accommodation part 1332 is located at an end that is of the side wall 1301 and that faces the substrate 110. An end that is of the second sealing part 242 and that is close to the housing 130 is accommodated in the second accommodation part 1332, and an end that is of the second sealing part 242 and that is close to the substrate 110 abuts against the substrate 110, to improve sealing reliability of the second sealing part 242 between the housing 130 and the substrate 110.

Still referring to FIG. 12, a first groove 221 is disposed on a surface that is of the heat dissipation member 220 and that faces the semiconductor device 100, and the end that is of the first sealing part 241 and that is close to the heat dissipation member 220 is accommodated in the first groove 221, to further improve sealing reliability of the first sealing part 241 between the housing 130 and the heat dissipation member 220. In a possible implementation, a depth range of the first groove 221 may be set to 1 mm to 2 mm. For example, a depth of the first groove 221 may be set to 1 mm, 1.3 mm, 1.5 mm, 1.7 mm, 2 mm, or any value between 1 mm to 2 mm based on an actual requirement.

A second groove 111 is disposed on a surface that is of the substrate 110 and that faces the housing 130, and the end that is of the second sealing part 242 and that is close to the substrate 110 is accommodated in the second groove 111, to further improve sealing reliability of the second sealing part 242 between the housing 130 and the substrate 110.

In another possible implementation, the first groove 221 may not be disposed on the surface that is of the heat dissipation member 220 and that faces the housing 130, so that the end that is of the first sealing part 241 and that is close to the heat dissipation member 220 directly abuts against and is pressed against the surface that is of the heat dissipation member 220 and that faces the housing 130. The second groove 111 may not be disposed on the surface that is of the substrate 110 and that faces the housing 130, so that the end that is of the sealing member 240 and that is close to the substrate 110 directly abuts against and is pressed against the surface that is of the substrate 110 and that faces the housing 130.

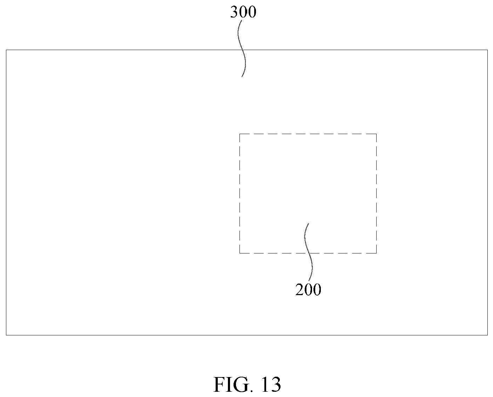

Referring to FIG. 13, an embodiment of this application further provides an electronic device 300. The electronic device 300 includes at least the foregoing integrated circuit 200.

The foregoing integrated circuit 200 is disposed in the electronic device 300 provided in this embodiment of this application. A sealing member is disposed in the integrated circuit 200. Therefore, when the integrated circuit 200 is immersed in electronic fluorinated liquid for heat dissipation, the sealing member may isolate the electronic fluorinated liquid from a thermal interface material of the integrated circuit 200, to prevent the electronic fluorinated liquid from being in contact with the thermal interface material, thereby helping ensure reliability of the thermal interface material, and helping ensure a heat dissipation effect of the integrated circuit 200. Further, it helps ensure performance and a heat dissipation effect of the electronic device 300, to help optimize an experience effect of the electronic device 300, and help ensure stability of signal transmission in the electronic device 300, and ensure normal working of the electronic device 300.

In some embodiments of this application, the electronic device 300 may be a server, or the server may include at least one electronic device 300. The foregoing integrated circuit is disposed in the server. Therefore, when the server is immersed in electronic fluorinated liquid for heat dissipation, the sealing member of the integrated circuit may isolate the electronic fluorinated liquid from the thermal interface material of the integrated circuit 200, to prevent the electronic fluorinated liquid from being in contact with the thermal interface material, thereby helping ensure reliability of the thermal interface material, and helping ensure a heat dissipation effect of the integrated circuit. Further, it helps ensure performance and a heat dissipation effect of the server, to help optimize an experience effect of the server, and help ensure stability of signal transmission in the server, and ensure normal working of the server.

In the descriptions of the embodiments of this application, it should be noted that, unless otherwise specified or limited, terms "mount", "connected", and "connect" shall be understood in a broad sense, for example, may be a fixed connection, may be an indirect connection by using an intermediate medium, or may be a connection between the inside of two elements or an interaction relationship between two elements. Persons of ordinary skill in the art may understand specific meanings of the foregoing terms in the embodiments of this application based on a specific case.

In the specification, claims, and accompanying drawings of the embodiments of this application, the terms "first", "second", "third", "fourth", and so on (if any) are intended to distinguish between similar objects but do not necessarily indicate a specific order or sequence.

Finally, it should be noted that the foregoing embodiments are merely intended for describing the technical solutions of the embodiments of this application, instead of limiting the embodiments of this application. Although the embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of the embodiments of this application.

## Claims

1. An electronic device, comprising:
a circuit board;
a heat dissipation member, spaced apart from the circuit board; and
a semiconductor device, located between the circuit board and the heat dissipation member, wherein the semiconductor device is electrically connected to the circuit board, and a first thermal interface material is disposed between the semiconductor device and the heat dissipation member, wherein
the semiconductor device comprises:
a substrate, connected to the circuit board;
a die, connected to a surface that is of the substrate and that faces away from the circuit board; and
a housing, fixed to the substrate and around the die, wherein
the housing comprises a first side wall and a second side wall, a sealing member is disposed between the first side wall and the second side wall, and the sealing member is sealing between the housing and the heat dissipation member, and between the housing and the substrate.

2. The electronic device according to claim 1, wherein an accommodation groove is disposed between the first side wall and the second side wall, and the accommodation groove extends in a direction pointing from the heat dissipation member to the circuit board, and penetrates through the housing; and
the sealing member is accommodated in the accommodation groove, an end that is of the sealing member and that is close to the heat dissipation member abuts against the heat dissipation member, and an end that is of the sealing member and that is close to the substrate abuts against the substrate.

3. The electronic device according to claim 2, wherein a first groove is disposed on a surface that is of the heat dissipation member and that faces the semiconductor device, and the end that is of the sealing member and that is close to the heat dissipation member is accommodated in the first groove.

4. The electronic device according to claim 2 or 3, wherein a second groove is disposed on a surface that is of the substrate and that faces the housing, and the end that is of the sealing member and that is close to the substrate is accommodated in the second groove.

5. The electronic device according to any one of claims 2 to 4, wherein a width of an orthographic projection, on the housing, of a part that is of the sealing member and that is located between the housing and the heat dissipation member , is greater than a width of the accommodation groove.

6. The electronic device according to any one of claims 1 to 5, wherein the material of the sealing member comprises at least one of silica gel or butyronitrile.

7. The electronic device according to claim 1, wherein a first accommodation part and a second accommodation part are disposed between the first side wall and the second side wall, the first accommodation part is located at an end that is of the housing and that faces the heat dissipation member, and the second accommodation part is located at an end that is of the housing and that faces the substrate;
the sealing member comprises a first sealing part and a second sealing part; and
the first sealing part is accommodated in the first accommodation part, an end that is of the first sealing part and that is close to the heat dissipation member abuts against the heat dissipation member, the second sealing part is accommodated in the second accommodation part, and an end that is of the second sealing part and that is close to the substrate abuts against the substrate.

8. The electronic device according to claim 7, wherein materials of the first sealing part and the second sealing part are the same, or materials of the first sealing part and the second sealing part are different.

9. The electronic device according to any one of claims 1 to 8, wherein the housing further comprises a top wall, and the top wall is connected to an end that is of the first side wall and that is close to the heat dissipation member;
the first thermal interface material is located between the top wall and the heat dissipation member; and
a second thermal interface material is disposed between the top wall and the die.

10. A server, wherein the server comprises at least one electronic device according to any one of claims 1 to 9.
